Europäisches Patentamt

European Patent Office

Office européen des brevets

(19)

(11) Veröffentlichungsnummer: 0 387 665
A2

## (12) EUROPÄISCHE PATENTANMELDUNG

(21) Anmeldenummer: 90104260.6

(22) Anmeldetag: 06.03.90

(51) Int. Cl.⁵: H05K 7/20

(30) Priorität: 06.03.89 DD 326313

(43) Veröffentlichungstag der Anmeldung:
19.09.90 Patentblatt 90/38

(84) Benannte Vertragsstaaten:
BE CH DE FR GB IT LI

(71) Anmelder: VEB Elektroprojekt und
Anlagenbau Berlin
Rhinstrasse 100
DDR-1140 Berlin(DD)

(72) Erfinder: Illig, Heinz
Ho-Chi-Minh-Strasse 5
DDR-Berlin 1056(DD)
Erfinder: Kindermann, Gerd
Rosenfelder Ring 56
DDR-Berlin 1136(DD)

(74) Vertreter: Patentanwälte Beetz sen. - Beetz
jun. Timpe - Siegfried - Schmitt-Fumian-
Mayr
Steinsdorfstrasse 10
D-8000 München 22(DE)

(54) Leistungselektronisches Gerät.

(57) Die Erfindung betrifft ein leistungselektronisches Gerät und insbesondere ein Stromrichtergerät, das aus einzelnen elektrischen Funktionseinheiten, wie Leistungsteil, Netzteil, Ansteuer- und Bedienteil oder deren Kombinationen (b, c), und einem auch als Trägerkörper dienenden Kühlkörper (a), der die leistungselektronischen Bauelemente trägt, besteht; es ist dadurch gekennzeichnet, daß
- die elektrischen Funktionseinheiten (b, c) entsprechend ihrer Schaltung konstruktiv getrennt voneinander aufgebaut sind,
- jede elektrische Funktionseinheit (b, c) an mindestens zwei gegenüberliegenden Seiten (1, 2) Seitenteile (1b, 2b; 1c, 2c) aufweist, wobei die Seitenteile (1b, 2b; 1c, 2c) aller Funktionseinheiten (b, c) an den Kanten, an denen sie miteinander verbunden sind, Mittel (3) zur lösbaren Verbindung untereinander aufweisen, und die Funktionseinheiten (b, c) entsprechend ihrem inneren Aufbau gleich oder unterschiedliche Schrittweiten aufweisen und über die Mittel (3) lösbar miteinander verbunden sind,
- der Kühlkörper (a) mit zwei einander gegenüberliegenden Seitenteilen (1a, 2a) verbunden ist und den Trägerkörper des leistungselektronischen Geräts bildet,
- die Seitenteile (1a, 2a) über Mittel (3) zur lösbaren Verbindung mit der angrenzenden Funktionseinheit (b) verbunden sind,

und
- die Seitenteile (1a, 2a) eine den Abmessungen des Kühlkörpers (a) einschließlich der leistungselektronischen Bauelemente entsprechende Schrittweite aufweisen.

## LEISTUNGSELEKTRONISCHES GERÄT

Die Erfindung betrifft ein leistungselektronisches Gerät, insbesondere ein Stromrichtergerät, das aus einzelnen elektrischen Funktionseinheiten, wie Leistungsteil, Netzteil, Ansteuer- und Bedienteil oder deren Kombinationen, sowie aus einem auch als Trägerkörper dienenden Kühlkörper besteht, der die leistungselektronischen Bauelemente trägt.

Bei Stromrichtergeräten ist es allgemein bekannt, alle zugehörigen elektrischen und mechanischen Funktionselemente in einem Kompaktgefäß unterzubringen. Eine Modifizierung solcher Geräte bezüglich Leistung und Komfort ist entweder überhaupt nicht möglich oder erfolgt meist durch unterschiedliche Gehäuseabmessungen bzw. durch volumenmäßig nicht vollständig ausgenutzte Geräte. Es werden dabei viele Geräte zu einer Typenreihe zusammengefaßt, was einen hohen technologischen Aufwand erfordert und bezüglich Servicefreundlichkeit gerätespezifische Anforderungen stellt.

Ein weiterer Trend besteht darin, Bauelemente und Baugruppen unterschiedlichster Funktionen in fester Zuordnung zueinander in einer kompakten Baueinheit unterzubringen, die selbsttragend alle wesentlichen elektrischen und mechanischen Funktionselemente vereinigt. So sind gemäß DE-A-2 611 260 und auch DE-A-3 630 830 die verschiedenen elektrischen Funktionsteile in mehreren Etagen, d.h. in mehreren Lagen, mit gegenseitigem Abstand auf einem Trägerkörper bzw. einer Grundplatte angeordnet, wobei dieser Trägerkörper gleichzeitig als Kühlkörper dient. Dabei ist eine Etage der Montageebene nicht allein den Bauelementen einer elektrischen Funktionseinheit vorbehalten. Vielmehr spielen Gesichtspunkte, wie z.B. Verlustwärme, kurze Verdrahtung und Bedienbarkeit, für die Aufteilung der Bauelemente auf die einzelnen Ebenen eine wesentliche Rolle. Je nach Verwendungszweck werden solche Kompaktgeräte in Gestelle oder Schaltschränke eingebaut und sind zum Schutz der Bauteile vor mechanischen Beschädigungen und Verschmutzung, wie aus DE-A-3 609 037 hervorgeht, mit einer Abdeckung versehen. Der Nachteil einer solchen Konstruktion besteht in der erschwerten Zugänglichkeit bzw. verringerter Servicefreundlichkeit derartiger Geräte. Eine schnelle Reparatur kann somit nur durch sofortigen Austausch des gesamten Gerätes erfolgen.

Aufgabe der Erfindung ist es deshalb, ein leistungselektronisches Gerät und insbesondere ein Stromrichtergerät anzugeben, bei dem die oben geschilderten Nachteile des Standes der Technik vermieden sind und das aus einzelnen elektrischen Funktionseinheiten, wie Leistungsteil, Netzteil, Ansteuer- und Bedienteil, sowie aus einem auch als Trägerkörper dienenden und die leistungselektronischen Bauelemente tragenden Kühlkörper besteht und das eine getrennte Fertigung der elektrischen Funktionseinheiten ermöglicht, die in baulichen Varianten miteinander verbunden und zu modifizierten Gesamtgeräten zusammengestellt werden können, wobei gleichzeitig auch erhöhte Anforderungen an die Servicefreundlichkeit zu berücksichtigen sind.

Die Aufgabe wird anspruchsgemäß gelöst. Die abhängigen Ansprüche betreffen vorteilhafte Ausführungsformen.

Das erfindungsgemäße leistungselektronische Gerät, das insbesondere ein Stromrichtergerät ist, besteht aus einzelnen elektrischen Funktionseinheiten, wie Leistungsteil, Netzteil, Ansteuer- und Bedienteil oder deren Kombinationen, und einem auch als Trägerkörper dienenden Kühlkörper, der die leistungselektronischen Bauelemente trägt, und ist dadurch gekennzeichnet, daß

- die elektrischen Funktionseinheiten entsprechend ihrer Schaltung konstruktiv getrennt voneinander aufgebaut sind,

- jede elektrische Funktionseinheit an mindestens zwei gegenüberliegenden Seiten Seitenteile aufweist, wobei die Seitenteile aller Funktionseinheiten an den Kanten, an denen sie miteinander verbunden sind, Mittel zur lösbaren Verbindung untereinander aufweisen, und die Funktionseinheiten entsprechend ihrem inneren Aufbau gleiche oder unterschiedliche Schrittweiten aufweisen und über die Mittel lösbar miteinander verbunden sind,

- der Kühlkörper mit zwei einander gegenüberliegenden Seitenteilen verbunden ist und den Trägerkörper des leistungselektronischen Geräts bildet,

- die Seitenteile über Mittel zur lösbaren Verbindung mit der angrenzenden Funktionseinheit verbunden sind, und

- die Seitenteile eine den Abmessungen des Kühlkörpers einschließlich der leistungselektronischen Bauelemente entsprechende Schrittweite aufweisen.

Das Gerät ist vorzugsweise von rechteckigem Querschnitt.

Um den Gesamtaufbau des Gerätes hinsichtlich der mechanischen Festigkeit weiter zu verbessern und um eine zusätzliche Montageebene für Bauelemente bzw. Baugruppen zu schaffen, sind in weiterer Ausgestaltung der Erfindung die beiden gegenüberliegenden Seitenteile zumindest der äußeren Funktionseinheit zu einer C-förmigen Aufnahme verbunden.

Nach einem weiteren Merkmal der Erfindung ist wenigstens die vordere Funktionseinheit um eine parallel zur Frontplattenunterkante des Gerätes verlaufende Schwenkachse um einen Winkel abklappbar, wodurch eine gute Zugänglichkeit erreicht wird.

Nach einer vorteilhaften Ausbildung der Erfindung ist an den Seitenteilen der vorderen Funktionseinheit des Gerätes, vorteilhaft über Mittel zur lösbaren Verbindung, die insbesondere Abkantungen umfassen, eine Frontplatte befestigt. Schließlich erhält in einer anderen Ausbildung der Erfindung die vordere Funktionseinheit des Gerätes zwei weitere Seitenteile mit gegenüber den anderen Seitenteilen geringerer Schrittweite, auf deren äußeren Abkantungen eine Frontplatte befestigt ist. Das ist dann zweckmäßig, wenn Bauteile bzw. Baugruppen die herkömmliche Front der vorderen Funktionseinheit überragen.

Durch die Erfindung wird somit erreicht, daß die einzelnen Funktionseinheiten sowohl getrennt voneinander gefertigt als auch getrennt voneinander eingesetzt werden können und in unterschiedlichsten Varianten, den Kundenwünschen entsprechend, zu einem modifizierten, kundenspezifischen Gerät zusammenstellbar sind. Gleichzeitig wird eine rationelle Fertigung entsprechender Geräte ermöglicht. Weiterhin sind solche Geräte sehr servicefreundlich und in der Ersatzteilhaltung vorteilhaft, da sie bei Störungen nicht komplett ausgetauscht werden müssen.

Im folgenden wird die Erfindung an einem Ausführungsbeispiel näher erläutert:

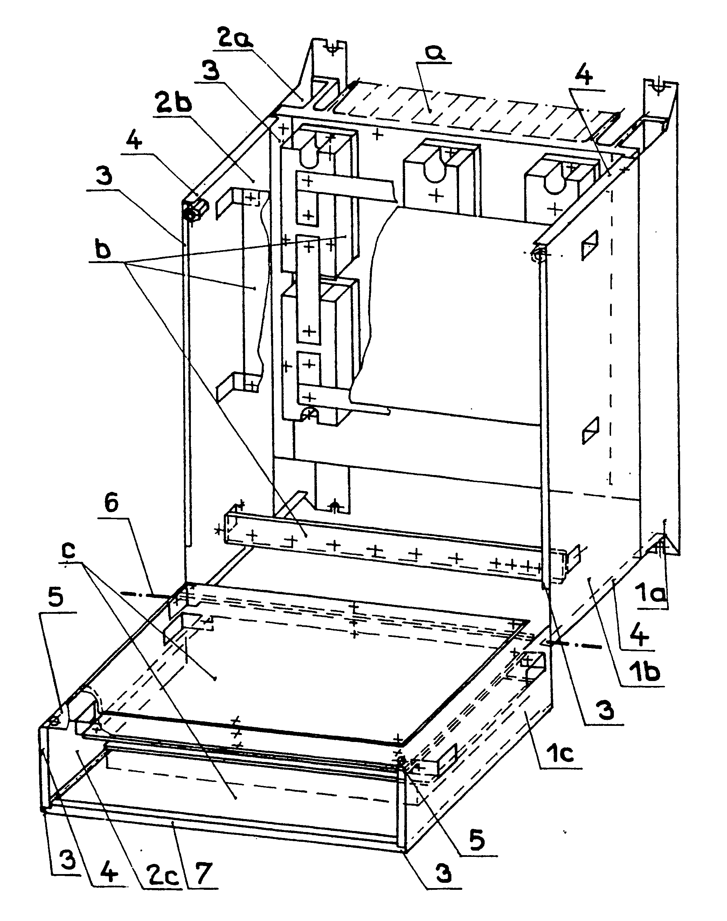

In der Zeichnung ist schematisch in perspektivischer Darstellung der Aufbau eines Stromrichtergerätes gezeigt, das aus zwei Funktionseinheiten b und c sowie einem Kühlkörper a mit leistungselektronischen Bauelementen besteht, wobei die vordere Funktionseinheit c abgeklappt ist. Dabei können die Funktionseinheit b ein Leistungsteil, das beispielsweise das Netzteil mit aufnehmen kann, und die Funktionseinheit c die Steuer- und Regelelektronik sein, die wiederum die Bedien- und Anzeigeelemente einschließen kann. Jede Funktionseinheit b, c sowie der Kühlkörper a weisen zwei parallel gegenüberliegende Seiten 1, 2 auf, deren Abstand voneinander gleich ist, wobei die Seitenteile 1a, 2a; 1b, 2b; 1c, 2c entsprechend ihrem inneren Aufbau aber unterschiedliche Schrittweiten aufweisen können. Im Auführungsbeispiel ist die Schrittweite der Seitenteile 1b, 2b der Funktionseinheit b größer als die Schrittweite der Seitenteile 1a, 2a bzw. 1c, 2c des Kühlkörpers a bzw. der Funktionseinheit c ausgeführt. Zwei gegenüberliegende Seitenteile 1a, 2a die eine dem Kühlkörper a angepaßte Schrittweite besitzen, bilden mit diesem den Trägerkörper des Stromrichtergerätes. Diese beiden Seitenteile 1a, 2a sind so ausgeführt, daß sie an einer Wand oder an einem Gestell bzw. in einem Schrank befestigt werden können. An diesen zusammen mit dem Kühlkörper als Trägerkörper fungierenden Seitenteilen 1a, 2a können nun beliebige weitere Funktionseinheiten b, c zu einem einer bestimmten Variante entsprechenden Gerät aufgereiht werden. Die Aneinanderfügung der jeweils aufzureihenden Funktionseinheiten b, c und des Kühlkörpers a durch erfolgt durch lösbare Verbindungen (3) zwischen den aneinanderstoßenden senkrechten Abkantungen aller aneinanderzufügenden Seitenteile 1a, 2a; 1b, 2b; 1c, 2c. Die Seitenteile 1b, 2b und 1c, 2c können zur Stabilisierung zusätzlich zwei weitere Abkantungen 4 in den waagerechten Ebenen erhalten, welche gleichzeitig als Griffmulde und als Befestigungsfläche für Abdeckungen dienen können. Durch eine Verschraubung der senkrechten Abkantungen wird eine ausreichende Stabilität des Gesamtgerätes erzielt. Verstärkt wird die Tragfähigkeit noch durch den inneren Aufbau, da z.B. der Kühlkörper, die Klemmleisten und Leiterplatten, die die jeweils gegenüberliegenden Seitenteile 1a, 2a; 1b, 2b; 1c, 2c verbinden, für eine hohe Quersteifigkeit sorgen. Auch die Möglichkeit, die zwei zu einer Funktionseinheit gehörenden gegenüberliegenden Seitenteile 1c, 2c zu einer C-förmigen Aufnahme 5 auszubilden, verstärkt den Gesamtaufbau und schafft zusätzlich eine Montageebene für Bauelemente bzw. Baugruppen. Eine gute Zugänglichkeit zu einzelnen Bauelementen der Funktionseinheiten b, c sowie des Kühlkörpers a wird dadurch erzielt, daß die Funktionseinheit c um eine parallel zur Frontplattenunterkante des Stromrichtergerätes verlaufende Schwenkachse 6 abklappbar gestaltet ist. Bei der Realisierung einer abklappbaren Funktionseinheit c bietet es sich an, die lösbaren Verbindungen der Funktionseinheit c über die Abkantungen 4 der waagerechten Ebenen auszuführen, was mittels Laschen erfolgen kann.

Auf den vorderen Abkantungen 3 der Seitenteile 1c, 2c der das Stromrichtergerät abschließenden Funktionseinheit c kann eine Frontplatte 7 montiert werden. Sofern Bauelemente bei bestimmten Gerätevarianten über die Funktionseinheit c hinausragen, können zwei weitere Seitenteile mit gegebenenfalls gegenüber den anderen Seitenteilen geringerer Schrittweite vorgesehen werden, wobei diese zusätzlichen Einbauten ebenfalls durch eine Frontplatte abgedeckt werden können.

**Ansprüche**

1. Leistungselektronisches Gerät, inbesondere Stromrichtergerät, bestehend aus einzelnen elektrischen Funktionseinheiten, wie Leistungsteil, Netzteil, Ansteuer-und Bedienteil oder deren Kombinationen (b, c), und einem auch als Trägerkörper dienenden Kühlkörper (a), der die leistungselektronischen Bauelemente trägt,
dadurch **gekennzeichnet,** daß

- die elektrischen Funktionseinheiten (b, c) entsprechend ihrer Schaltung konstruktiv getrennt voneinander aufgebaut sind,
- jede elektrische Funktionseinheit (b, c) an mindestens zwei gegenüberliegenden Seiten (1, 2) Seitenteile (1b, 2b; 1c, 2c) aufweist, wobei die Seitenteile (1b, 2b; 1c, 2c) aller Funktionseinheiten (b, c) an den Kanten, an denen sie miteinander verbunden sind, Mittel (3) zur lösbaren Verbindung untereinander aufweisen und die Funktionseinheiten (b, c) entsprechend ihrem inneren Aufbau gleiche oder unterschiedliche Schrittweiten aufweisen und über die Mittel (3) lösbar miteinander verbunden sind,
- der Kühlkörper (a) mit zwei einander gegenüberliegenden Seitenteilen (1a, 2a) verbunden ist und den Trägerkörper des leistungselektronischen Geräts bildet,
- die Seitenteile (1a, 2a) über Mittel (3) zur lösbaren Verbindung mit der angrenzenden Funktionseinheit (b) verbunden sind
und
- die Seitenteile (1a, 2a) eine den Abmessungen des Kühlkörpers (a) einschließlich der leistungselektronischen Bauelemente entsprechende Schrittweite aufweisen.

2. Gerät nach Anspruch 1,
dadurch gekennzeichnet, daß die beiden gegenüberliegenden Seitenteile (1c, 2c) zumindest der äußeren Funktionseinheit (c) zu einer C-förmigen Aufnahme (5) verbunden sind.

3. Gerät nach den Ansprüchen 1 und 2,
dadurch gekennzeichnet, daß wenigstens die vordere Funktionseinheit (c) um eine parallel zur Frontseitenunterkante des Gerätes verlaufende Schwenkachse (6) um einen Winkel abklappbar ist.

4. Gerät nach einem der Ansprüche 1 bis 3,
dadurch gekennzeichnet, daß die Mittel (3) zur lösbaren Verbindung Abkantungen aufweisen.

5. Gerät nach Anspruch 4,
dadurch gekennzeichnet, daß auf den äußeren Abkantungen (3) der vorderen Funktionseinheit (c) eine Frontplatte (7) angeordnet ist.

6. Gerät nach Anspruch 5,
dadurch gekennzeichnet, daß an der vorderen Funktionseinheit (c) zwei weitere Seitenteile mit gegenüber den anderen Seitenteilen (1a, 2a; 1b, 2b; 1c, 2c) geringerer Schrittweite vorgesehen sind, auf deren äußeren Abkantungen die Frontplatte (7) befestigt ist.